# EUROPÄISCHE PATENTANMELDUNG

(11) **EP 4 471 355 A1**
(43) Veröffentlichungstag der Anmeldung: **04.12.2024**
(21) Anmeldenummer: 24169527.9
(22) Anmeldetag: 10.04.2024
(51) Int. Cl.: F25B 5/02, F25B 39/00, F25B 39/02, F25D 19/00, F25D 21/00, F25D 23/00, F28F 3/14, F28F 17/00

(54) **ROLLBOND-VERDAMPFER-PLATTE**

(30) Priorität: 30.05.2023 DE 102023114063
(71) Anmelder: Binder GmbH, 78532 Tuttlingen (DE)
(72) Erfinder: BUSCHLE, Jochen, 78532 Tuttlingen (DE)
(74) Vertreter: Westphal, Mussgnug & Partner Patentanwälte mbB

(57) **Zusammenfassung**

Die Erfindung betrifft eine Rollbond-Verdampfer-Platte (10, 10') mit einer Breite (BR) und einer Höhe (HR), wobei die Rollbond-Verdampfer-Platte (10, 10') wenigstens einen Ausschnitt (20) umfasst, welcher an mindestens drei Seitenkanten (20b, 20c, 20d) von der Rollbond-Verdampfer-Platte (10, 10') begrenzt ist.

Ferner betrifft die Erfindung einen Kältemittelkreis (30) mit einer solchen Rollbond-Verdampfer-Platte (10, 10') sowie einen Laborschrank, Klimaschrank, Kälteschrank oder Umweltsimulationsschrank (50) mit einer solchen Rollbond-Verdampfer-Platte (10, 10').

## Beschreibung

Die Erfindung betrifft eine Rollbond-Verdampfer-Platte, einen Kältemittelkreis mit einer solchen Rollbond-Verdampfer-Platte sowie einen Laborschrank, Klimaschrank, Kälteschrank oder Umweltsimulationsschrank mit einer solchen Rollbond-Verdampfer-Platte.

Als Rollbond-Verfahren bezeichnet man ein Zusammenfügen von zwei Blechen durch Walzen bei hohem Druck, wobei bestimmte Teile des Blechs ausgespart oder mit Trennmitteln behandelt werden, so dass sie sich dort nicht verbinden können. Diese Bereiche können nachfolgend mittels Druckluft aufgeblasen werden, so dass Kanäle entstehen können.

Bekannt ist es, eine durch das Rollbond-Verfahren hergestellte Verdampfer-Platte, im Folgenden als Rollbond-Verdampfer-Platte bezeichnet, als Kühlfläche in Laborschränken, Klimaschränken, Kälteschränken oder Umweltsimulationsschränken einzusetzen, um im Innenraum dieser Schränke eine gewünschte Temperatur einstellen zu können.

In derartigen Schränken besteht das Problem, dass bei zu hoher Luftfeuchtigkeit bei entsprechend niedriger Temperatur Kondensat entsteht, welches zu unerwünschter Tropfenbildung führen kann. Um zu verhindern, dass sich Kondensat an beliebigen Stellen im Innenraum dieser Schränke bildet, ist es bekannt, gezielt Entfeuchtungsflächen vorzusehen. Die EP 0 758 732 A2 offenbart dazu ein Kühlgerät mit einem Normalkühlraum und einem Tiefkühlfach, dessen Verdampfer aus zwei in Reihe geschalteten Verdampferabschnitten mit das Kältemittel führenden Rohrabschnitten besteht, von denen der Abschnitt, in den der mit einer Steuereinrichtung versehene Kompressor das Kältemittel einleitet, dem Tiefkühlfach zugeordnet ist, wobei der dem Normalkühlraum zugeordnete Verdampferabschnitt aus einer Platte aus gut wärmeleitendem Material besteht, deren Größe auf die zur Entfeuchtung benötigte Fläche ausgelegt ist, wobei die Platte derart mit dem das Kältemittel führenden Rohrabschnitt verbunden ist, dass dieser bei im wesentlichen gleicher Temperaturverteilung die für den Normalkühlraum erforderliche Kälteleistung zugeführt wird. Nachteilig bei einer derartigen Ausgestaltung ist, dass aufgrund der Kopplung zwischen Verdampferabschnitt und Entfeuchtung eine sehr genaue Abstimmung erfolgen muss.

Die Aufgabe der Erfindung besteht daher darin, eine Verdampfer-Platte insbesondere für Laborschränke, Klimaschränke, Kälteschränke oder Umweltsimulationsschränke bereitzustellen, welche eine verbesserte Entfeuchtung ermöglicht.

Die Aufgabe wird erfindungsgemäß gelöst durch eine Rollbond-Verdampfer-Platte mit den Merkmalen des Anspruchs 1, einen Kältemittelkreis mit einer solchen Rollbond-Verdampfer-Platte mit den Merkmalen des Anspruchs 8 sowie einen Laborschrank, Klimaschrank, Kälteschrank oder Umweltsimulationsschrank mit den Merkmalen des Anspruchs 13.

Vorteilhafte Ausgestaltungen und Weiterbildung der Erfindung sind in den abhängigen Ansprüchen angegeben.

Die erfindungsgemäße Rollbond-Verdampfer-Platte mit einer Breite und einer Höhe zeichnet sich dadurch aus, dass sie wenigstens einen Ausschnitt umfasst, welcher an mindestens drei Seitenkanten von der Rollbond-Verdampfer-Platte begrenzt ist. Unter einem Ausschnitt soll im Folgenden insbesondere ein Durchbruch von einer Vorderseite der Rollbond-Verdampfer-Platte zu einer Rückseite der Rollbond-Verdampfer-Platte verstanden werden.

Der Ausschnitt weist insbesondere eine rechteckige Form mit einer Breite und einer Höhe sowie vier Seitenkanten auf. Die Rollbond-Verdampfer-Platte weist ebenfalls insbesondere eine rechteckige Form mit einer Breite und einer Höhe sowie vier Seitenkanten auf. Wenn der Ausschnitt an mindestens drei Seitenkanten von der Rollbond-Verdampfer-Platte begrenzt ist, kann dies mit anderen Worten ausgedrückt heißen, dass höchstens eine Seitenkante des Ausschnitts mit einer Seitenkante der Rollbond-Verdampfer-Platte zusammenfällt. In diesem Fall bildet der Ausschnitt eine seitliche Aussparung in der Rollbond-Verdampfer-Platte.

Der erfindungsgemäße Ausschnitt weist den Vorteil auf, dass innerhalb dieses Ausschnitts eine separate Entfeuchtungsplatte angeordnet werden kann. Die Rollbond-Verdampfer-Platte kann somit ausschließlich zur Kühlung verwendet und für diesen Zweck optimiert werden, während die separate Entfeuchtungsplatte ausschließlich zur Entfeuchtung verwendet und für diesen Zweck optimiert werden kann. Zudem ermöglicht die Anordnung des Ausschnitts in der Rollbond-Verdampfer-Platte eine gezielte Positionierung einer Fläche, an welcher die Kondensation erfolgen soll, ohne den Kühleffekt durch die Rollbond-Verdampfer-Platte zu sehr zu beeinflussen.

Ist vorteilhafterweise der Ausschnitt an vier Seitenkanten von der Rollbond-Verdampfer-Platte begrenzt, kann dies mit anderen Worten ausgedrückt heißen, dass keine Seitenkante des Ausschnitts mit einer Seitenkante der Rollbond-Verdampfer-Platte zusammenfällt. In diesem Fall bildet der Ausschnitt einen Durchbruch im Innern der Rollbond-Verdampfer-Platte.

Vorzugsweise ist der Ausschnitt entlang der Breite etwa mittig angeordnet, um eine günstige Positionierung der separaten Entfeuchtungsplatte im Wesentlichen symmetrisch zur Längsachse der Rollbond-Verdampfer-Platte und damit insbesondere symmetrisch zur Längsachse im Innenraum eines Laborschranks, Klimaschranks, Kälteschranks oder Umweltsimulationsschranks ermöglichen zu können.

Gemäß einer Weiterbildung der Erfindung weist die Rollbond-Verdampfer-Platte zwei Ausschnitte auf, welche vorzugsweise symmetrisch zur Längsachse der Rollbond-Verdampfer-Platte angeordnet sind. Insbesondere bei größeren Laborschränken, Klimaschränken, Kälteschränken oder Umweltsimulationsschränken bietet es sich an, mehrere, beispielsweise zwei, Ausschnitte vorzusehen, um eine zuverlässige Entfeuchtung im gesamten Innenraum ermöglichen zu können. Durch eine symmetrische Anordnung kann eine gleichmäßige Entfeuchtung verbessert werden.

Vorteilhafterweise ist der Ausschnitt entlang der Höhe im unteren Drittel angeordnet, um eine günstige Positionierung der separaten Entfeuchtungsplatte relativ zu einem Kondensatablauf, welcher in der Regel am unteren Rand der Rollbond-Verdampfer-Platte angeordnet ist, ermöglichen zu können.

Gemäß einer vorteilhaften Weiterbildung der Erfindung weist der Ausschnitt eine Breite auf, welche weniger als 50%, vorzugsweise weniger als 40%, besonders bevorzugt weniger als 25%, der Breite der Rollbond-Verdampfer-Platte beträgt. Dadurch ist auch eine innerhalb des Ausschnitts angeordnete Entfeuchtungsplatte entsprechend klein ausgebildet, um einen möglichst kleinen Feuchtepunkt bereitstellen zu können und die durch die Rollbond-Verdampfer-Platte bereitgestellte Temperatur möglichst wenig zu beeinflussen.

Eine bevorzugte Ausführungsform der Erfindung sieht vor, dass der Ausschnitt eine Höhe aufweist, welche weniger als 50%, vorzugsweise weniger als 40%, besonders bevorzugt weniger als 25%, der Höhe der Rollbond-Verdampfer-Platte beträgt. Dadurch ist auch eine innerhalb des Ausschnitts angeordnete Entfeuchtungsplatte entsprechend klein ausgebildet, um einen möglichst kleinen Feuchtepunkt bereitstellen zu können und die durch die Rollbond-Verdampfer-Platte bereitgestellte Temperatur möglichst wenig zu beeinflussen.

Ein erfindungsgemäßer Kältemittelkreis mit einem Kompressor, einem Verflüssiger und einer erfindungsgemäßen Rollbond-Verdampfer-Platte umfasst eine in dem Ausschnitt angeordnete Entfeuchtungsplatte. Eine Entkopplung von Kühlung durch die Rollbond-Verdampfer-Platte und Entfeuchtung durch die Entfeuchtungsplatte ermöglicht eine optimierte Auslegung der beiden Platten für die jeweilige Funktion, wobei die Anordnung der Entfeuchtungsplatte in einem Ausschnitt in der Rollbond-Verdampfer-Platte eine günstige Positionierung der Entfeuchtungsplatte erlaubt.

Die Temperatur der Entfeuchtungsplatte kann dabei insbesondere unterschiedlich zu der Temperatur der Rollbond-Verdampfer-Platte sein, um die beiden Platten für die jeweilige Funktion optimal auslegen zu können.

Besonders bevorzugt ist die Temperatur der Entfeuchtungsplatte unabhängig von der Temperatur der Rollbond-Verdampfer-Platte steuerbar, um die gewünschte Temperatur für jede der Platten separat einstellen zu können. Gemäß einer alternativen bevorzugten Ausführungsform ist die Temperatur der Entfeuchtungsplatte mit einer festgelegten Differenz zu der Temperatur der Rollbond-Verdampfer-Platte einstellbar. Dadurch kann auf einfache Art und Weise insbesondere mit wenigen Komponenten sichergestellt werden, dass die Entfeuchtungsplatte in jeder Situation eine niedrigere Temperatur als die Rollbond-Verdampfer-Platte aufweist, um eine zuverlässige Entfeuchtung ermöglichen zu können.

Bei der Entfeuchtungsplatte kann es sich um eine gekühlte Platte handeln. Vorzugsweise ist die Entfeuchtungsplatte als weitere Rollbond-Verdampfer-Platte ausgebildet.

Gemäß einer vorteilhaften Weiterbildung der Erfindung sind die Rollbond-Verdampfer-Platte und die Entfeuchtungsplatte in dem Kältemittelkreis parallel geschaltet. Dies ermöglicht eine effektive Nutzung des Kältemittels.

Ein erfindungsgemäßer Laborschrank, Klimaschrank, Kälteschrank oder Umweltsimulationsschrank mit einem Probenraum umfasst eine erfindungsgemäße Rollbond-Verdampfer-Platte oder einen erfindungsgemäßen Kältemittelkreis, wobei die Rollbond-Verdampfer-Platte an der Außenseite des Probenraums, insbesondere an der Außenseite der Rückseite des Probenraums, angeordnet ist. Durch eine derartige Anordnung der Rollbond-Verdampfer-Platte wird eine effektive Kühlung des Probenraums ermöglicht.

Ein Ausführungsbeispiel der Erfindung wird anhand der nachfolgenden Figuren ausführlich erläutert. Es zeigen
- Fig. 1: eine schematische Darstellung eines ersten Ausführungsbeispiels einer erfindungsgemäßen Rollbond-Verdampfer-Platte mit einem Ausschnitt, wobei in dem Ausschnitt eine Entfeuchtungsplatte angeordnet ist,
- Fig. 2: eine Sicht auf die Rückwand eines Laborschranks, Klimaschranks, Kälteschranks oder Umweltsimulationsschranks, mit daran angeordneter Rollbond-Verdampfer-Platte gemäß Fig. 1,
- Fig. 3: eine Darstellung eines zweiten Ausführungsbeispiels einer erfindungsgemäßen Rollbond-Verdampfer-Platte mit einem Ausschnitt,
- Fig. 4: die Rollbond-Verdampfer-Platte gemäß Fig. 3 mit in dem Ausschnitt angeordneter Entfeuchtungsplatte,
- Fig. 5: eine Sicht auf die Rückwand eines Laborschranks, Klimaschranks, Kälteschranks oder Umweltsimulationsschranks, mit daran angeordneter Rollbond-Verdampfer-Platte gemäß Fig. 4 und

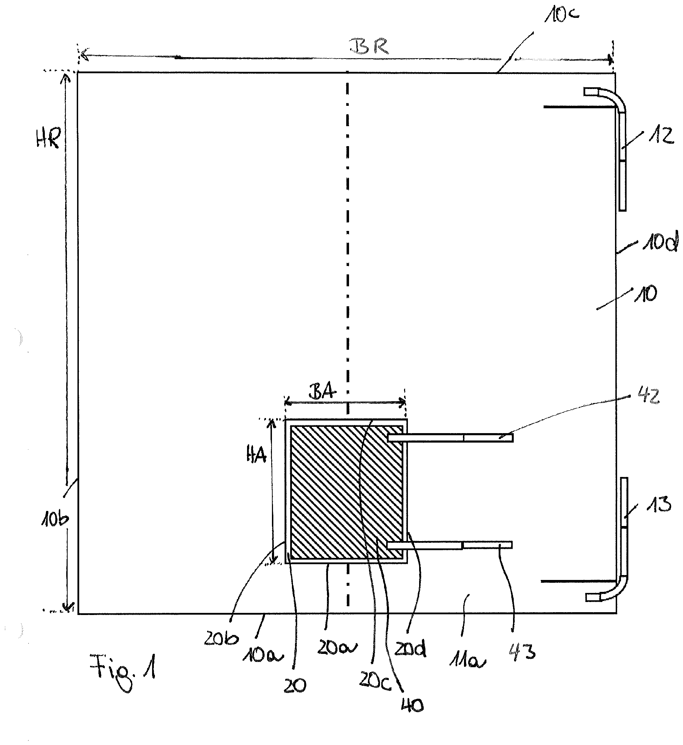

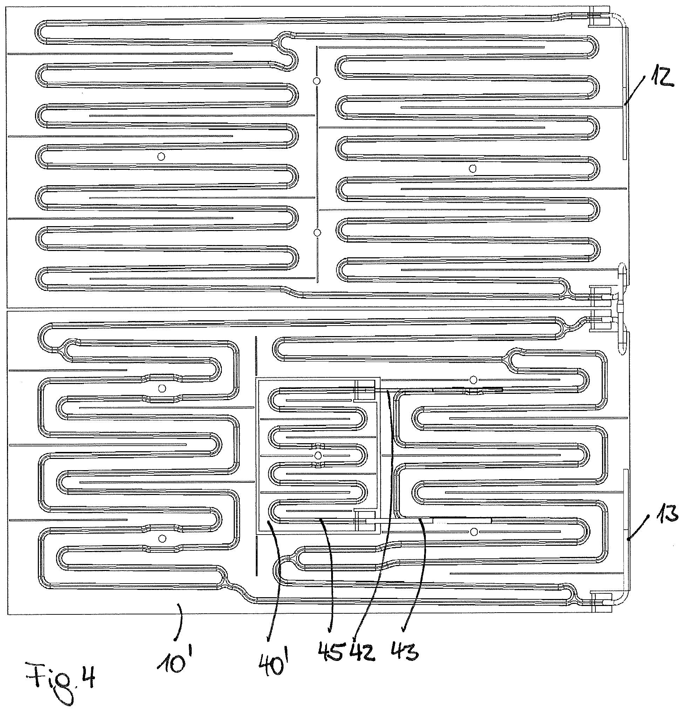

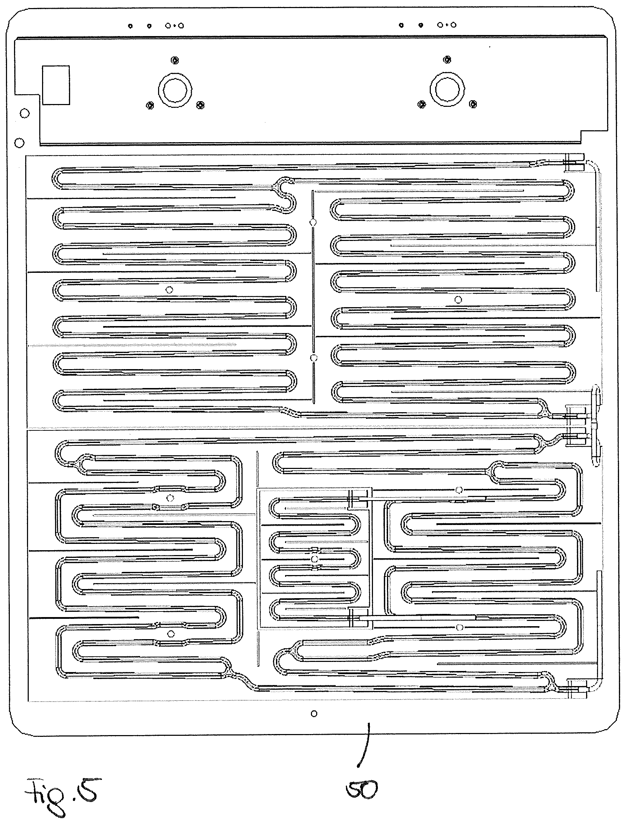

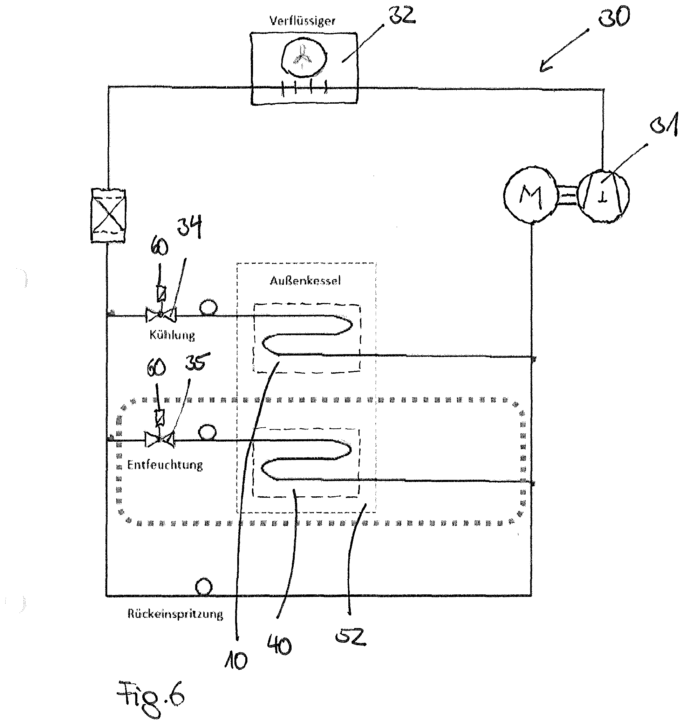

- Fig. 5: eine schematische Darstellung eines Kältemittelkreises mit einer Rollbond-Verdampfer-Platte gemäß Fig. 1 oder 4.

In allen Figuren bezeichnen gleiche Bezugsziffern gleiche oder funktionsgleiche Teile, wobei zur besseren Übersicht nicht sämtliche Bezugsziffern in sämtlichen Figuren angegeben sind.

Figur 1 zeigt eine schematische Darstellung eines ersten Ausführungsbeispiels einer Rollbond-Verdampfer-Platte 10. Die Rollbond-Verdampfer-Platte 10 ist im Rollbond-Verfahren durch Zusammenfügen von zwei Blechen durch Walzen bei hohem Druck hergestellt, wobei bestimmte Teile des Blechs ausgespart oder mit Trennmitteln behandelt werden, so dass sie sich dort nicht verbinden können. Diese Bereiche können nachfolgend mittels Druckluft aufgeblasen werden, so dass Kanäle entstehen können. Bei dem in Figur 1 dargestellten Ausführungsbeispiel sind lediglich ein Einlass 12 und ein Auslass 13 in einen in der Rollbond-Verdampfer-Platte 10 angeordneten Kanal dargestellt; der Kanal selbst ist in diesem Ausführungsbeispiel nicht gezeigt.

Die Rollbond-Verdampfer-Platte 10 ist im Wesentlichen rechteckig mit einer Vorderseite 11a, einer Rückseite (in den Figuren aufgrund der Draufsicht auf die Vorderseite 11a nicht erkennbar) und vier Seitenkanten 10a, 10b, 10c, 10d ausgebildet. Die Rollbond-Verdampfer-Platte 10 weist dabei eine Höhe HR und eine Breite BR auf.

Die Rollbond-Verdampfer-Platte 10 umfasst einen Ausschnitt 20, der insbesondere rechteckig mit einer Breite BA, einer Höhe HA und vier Seitenkanten 20a, 20b, 20c, 20d ausgebildet ist. Der Ausschnitt 20 reicht insbesondere von der Vorderseite 11a bis zur Rückseite und durchsetzt die Rollbond-Verdampfer-Platte 10 damit vollständig. Der Ausschnitt 20 ist an mindestens drei Seitenkanten 20b, 20c, 20d von der Rollbond-Verdampfer-Platte 10 begrenzt. In dem Fall würde die Seitenkante 20a auf der Seitenkante 10a der Rollbond-Verdampfer-Platte 10 liegen und der Ausschnitt 20 eine seitliche Ausnehmung bilden.

Bei den in den Figuren dargestellten Ausführungsbeispielen ist der Ausschnitt 20 an den vier Seitenkanten 20a, 20b, 20c, 20d von der Rollbond-Verdampfer-Platte 10 begrenzt. In diesem Fall bildet der Ausschnitt 20 einen Durchbruch im Innern der Rollbond-Verdampfer-Platte 10.

Der Ausschnitt 20 kann insbesondere entlang der Breite BR der Rollbond-Verdampfer-Platte 10 etwa mittig angeordnet sein. Sind mehrere Ausschnitte 20 vorhanden (nicht dargestellt), können diese insbesondere symmetrisch zur Längsachse der Rollbond-Verdampfer-Platte 10 angeordnet sein. Weiterhin kann der Ausschnitt 20 entlang der Höhe HR der Rollbond-Verdampfer-Platte 10 im unteren Drittel angeordnet sein (vgl. Fig. 1).

Die Breite BA des Ausschnitts 20 beträgt insbesondere weniger als 50%, vorzugsweise weniger als 40%, beispielsweise weniger als 25%, der Breite BR der Rollbond-Verdampfer-Platte 10. Die Höhe HA des Ausschnitts 20 beträgt insbesondere weniger als 50%, vorzugsweise weniger als 40%, beispielsweise weniger als 25%, der Höhe HR der Rollbond-Verdampfer-Platte 10 beträgt.

In dem Ausschnitt 20 kann wie in Figur 1 dargestellt eine Entfeuchtungsplatte 40 angeordnet sein. Diese ist in ihren Maßen insbesondere derart ausgestaltet, dass sie den Ausschnitt 20 im Wesentlichen ausfüllt. Die Entfeuchtungsplatte 40 kann beispielsweise ebenfalls als Rollbond-Verdampfer-Platte ausgebildet sein und einen Einlass 42 und einen Auslass 43 in einen in Figur 1 nicht dargestellten Kanal aufweisen.

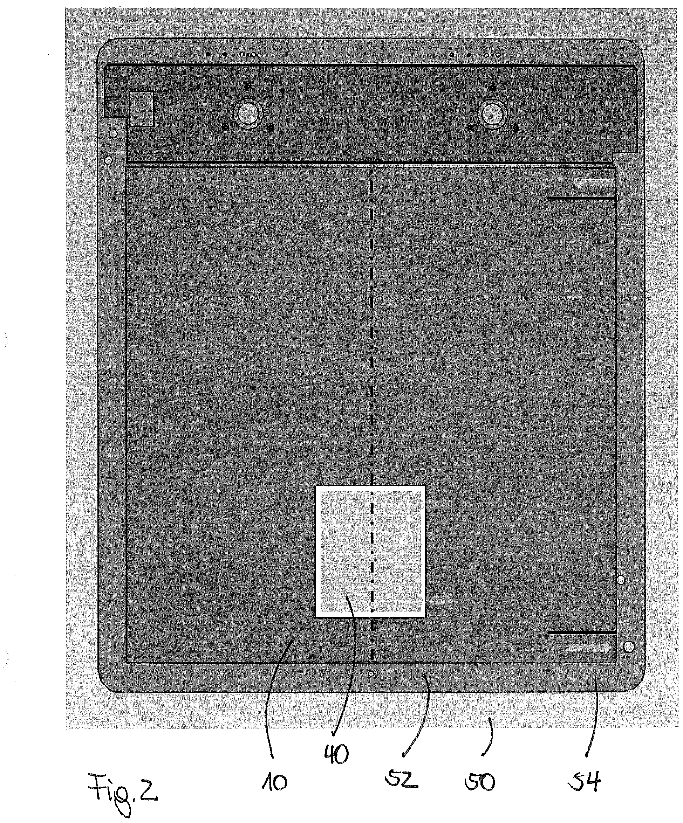

Figur 2 zeigt die Rollbond-Verdampfer-Platte 10 gemäß Figur 1 mit der Entfeuchtungsplatte 40 in einem Schrank 50, welcher als Laborschrank, Klimaschrank, Kälteschrank oder Umweltsimulationsschrank ausgebildet ist. Der Schrank 50 weist einen Probenraum 52 mit einer Rückwand 54 auf, wobei die Rollbond-Verdampfer-Platte 10 insbesondere an der Außenseite der Rückwand 54 angeordnet ist.

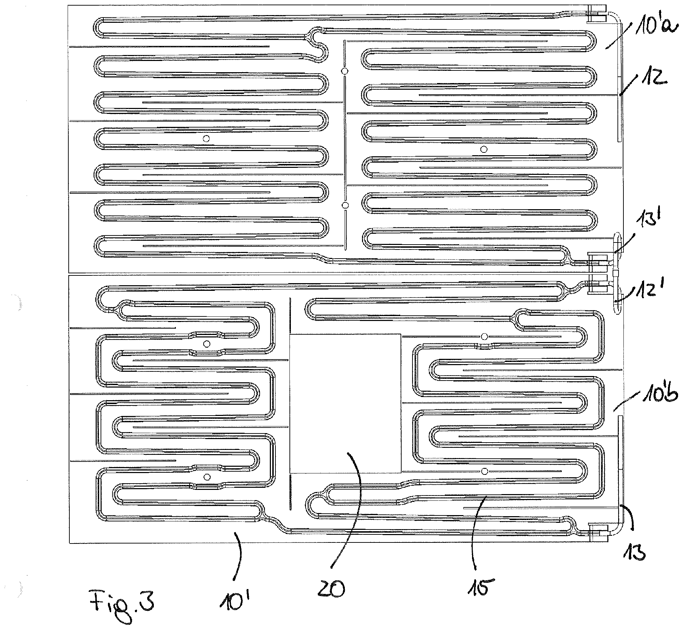

Das in Figur 3 dargestellte Ausführungsbeispiel einer Rollbond-Verdampfer-Platte 10` unterscheidet sich im Wesentlichen dadurch von der in Figur 1 dargestellten Rollbond-Verdampfer-Platte 10, dass zusätzlich der Kanal 15 zwischen dem Einlass 12 und dem Auslass 13 erkennbar ist. Weiterhin ist die Rollbond-Verdampfer-Platte 10` in der Höhe zweigeteilt mit einer oberen Rollbond-Verdampfer-Platte 10'a und einer unteren Rollbond-Verdampfer-Platte 10'b ausgebildet, wobei ein Auslass 13` der oberen Rollbond-Verdampfer-Platte 10'a direkt mit einem Einlass 12' der unteren Rollbond-Verdampfer-Platte 10'b verbunden ist. Der Ausschnitt 20 ist lediglich in der unteren Rollbond-Verdampfer-Platte 10'b angeordnet, während die obere Rollbond-Verdampfer-Platte 10'a keinen Ausschnitt aufweist. Durch eine derartige Reihenschaltung zweiter Rollbond-Verdampfer-Platte 10'a, 10'b kann auf einfache Art und Weise die Fläche des Rollbond-Verdampfer-Platte 10' vergrößert werden, beispielsweise, um diese an die Fläche des entsprechenden Schranks 50 anpassen zu können.

Figur 4 zeigt die Rollbond-Verdampfer-Platte 10' gemäß Figur 3 mit in dem Ausschnitt 20 angeordneter Entfeuchtungsplatte 40`, wobei diese sich im Wesentlichen dadurch von der in Figur 1 dargestellten Entfeuchtungsplatte 40 unterscheidet, dass zusätzlich der Kanal 45 zwischen dem Einlass 42 und dem Auslass 43 erkennbar ist. Figur 5 illustriert die Anordnung der Rollbond-Verdampfer-Platte 10' gemäß Figur 4 in dem Schrank 50.

Figur 5 zeigt schematisch einen Kältemittelkreis 30 mit einem Kompressor 31, einem Verflüssiger 32 und einer Rollbond-Verdampfer-Platte 10 mit Entfeuchtungsplatte 40 wie zuvor beschrieben, wobei die Temperatur der Entfeuchtungsplatte 40 unabhängig von der Temperatur der Rollbond-Verdampfer-Platte 10 regelbar ist. Die kann insbesondere dadurch erfolgen, dass die Rollbond-Verdampfer-Platte 10 und die Entfeuchtungsplatte 40 in dem Kältemittelkreis 30 parallel geschaltet sind. Der Zulauf von Kältemittel in die Rollbond-Verdampfer-Platte 10 kann über ein Ventil 34, der Zulauf von Kältemittel in die Entfeuchtungsplatte 40 über ein Ventil 35 geregelt werden. Die Ventile 34, 35 sind dabei insbesondere über eine Steuereinheit 60 ansteuerbar. Ein derartiger Kältemittelkreis 30 kann insbesondere in dem Schrank 50 gemäß Figuren 2 oder 5 zur Anwendung kommen.

Die unabhängige Temperaturregelung für die Rollbond-Verdampfer-Platte 10 und die Entfeuchtungsplatte 40 ermöglicht es, gezielt eine kältere Temperatur an der Entfeuchtungsplatte 40 einzustellen, um eine Kondensation lediglich an einer gewünschten Position innerhalb des Probenraums 52, nämlich an der Entfeuchtungsplatte 40, zu bewirken. Es besteht auch die Möglichkeit, an der Entfeuchtungsplatte 40 eine Temperatur einzustellen, die um einen festen Betrag niedriger ist als die Temperatur an der Rollbond-Verdampfer-Platte 10. Die Positionierung der Entfeuchtungsplatte 40 im Wesentlichen mittig im unteren Drittel der Rückwand 54 des Probenraums ermöglicht ein gutes Abführen des Kondensats ohne die durch die Rollbond-Verdampfer-Platte 10 bereitgestellte Temperaturverteilung zu sehr zu beeinflussen.

### Bezugszeichenliste

- 10: Rollbond-Verdampfer-Platte
- 10`: Rollbond-Verdampfer-Platte
- 10'a: obere Rollbond-Verdampfer-Platte
- 10'b: untere Rollbond-Verdampfer-Platte
- 10a: Seitenkante
- 10b: Seitenkante
- 10c: Seitenkante
- 10d: Seitenkante
- 11a: Vorderseite
- 12: Einlass
- 12`: Einlass
- 13: Auslass
- 13': Auslass
- 15: Kanal
- 20: Ausschnitt
- 20a: Seitenkante
- 20b: Seitenkante
- 20c: Seitenkante
- 20d: Seitenkante
- 30: Kältemittelkreis
- 31: Kompressor
- 32: Verflüssiger
- 34: Ventil
- 35: Ventil
- 40: Entfeuchtungsplatte
- 40': Entfeuchtungsplatte
- 42: Einlass
- 43: Auslass
- 45: Kanal
- 50: Schrank
- 52: Probenraum
- 54: Rückwand
- 60: Steuereinheit
- BR: Breite
- HR: Höhe
- BA: Breite
- HA: Höhe

## Patentansprüche

1. Rollbond-Verdampfer-Platte (10, 10`) mit einer Breite (BR) und einer Höhe (HR),
**dadurch gekennzeichnet, dass** die
Rollbond-Verdampfer-Platte (10, 10`) wenigstens einen Ausschnitt (20) umfasst, welcher an mindestens drei Seitenkanten (20b, 20c, 20d) von der Rollbond-Verdampfer-Platte (10, 10') begrenzt ist.

2. Rollbond-Verdampfer-Platte nach Anspruch 1,
**dadurch gekennzeichnet, dass** der
Ausschnitt (20) an vier Seitenkanten (20a, 20b, 20c, 20d) von der Rollbond-Verdampfer-Platte (10, 10') begrenzt ist.

3. Rollbond-Verdampfer-Platte nach einem der vorhergehenden Ansprüche,
**dadurch gekennzeichnet, dass** der
Ausschnitt (20) entlang der Breite (BR) der Rollbond-Verdampfer-Platte (10, 10') etwa mittig angeordnet ist.

4. Rollbond-Verdampfer-Platte nach einem der vorhergehenden Ansprüche,
**dadurch gekennzeichnet, dass** die
Rollbond-Verdampfer-Platte (10, 10') zwei Ausschnitte (20) aufweist, welche vorzugsweise symmetrisch zur Längsachse der Rollbond-Verdampfer-Platte (10, 10') angeordnet sind.

5. Rollbond-Verdampfer-Platte nach einem der vorhergehenden Ansprüche,
**dadurch gekennzeichnet, dass** der
Ausschnitt (20) entlang der Höhe (HR) der Rollbond-Verdampfer-Platte (10, 10') im unteren Drittel angeordnet ist.

6. Rollbond-Verdampfer-Platte nach einem der vorhergehenden Ansprüche,
**dadurch gekennzeichnet, dass** der
Ausschnitt (20) eine Breite (BA) aufweist, welche weniger als 50%, vorzugsweise weniger als 40%, besonders bevorzugt weniger als 25%, der Breite (BR) der Rollbond-Verdampfer-Platte (10, 10') beträgt.

7. Rollbond-Verdampfer-Platte nach einem der vorhergehenden Ansprüche,
**dadurch gekennzeichnet, dass** der
Ausschnitt (20) eine Höhe (HA) aufweist, welche weniger als 50%, vorzugsweise weniger als 40%, besonders bevorzugt weniger als 25%, der Höhe (HR) der Rollbond-Verdampfer-Platte (10) beträgt.

8. Kältemittelkreis (30) mit einem Kompressor (31), einem Verflüssiger (32) und einer Rollbond-Verdampfer-Platte (10, 10') nach einem der vorhergehenden Ansprüche, wobei in dem Ausschnitt (20) eine Entfeuchtungsplatte (40, 40`) angeordnet ist.

9. Kältemittelkreis nach Anspruch 8,
**dadurch gekennzeichnet, dass** die
Temperatur der Entfeuchtungsplatte (40, 40`) unterschiedlich zu der Temperatur der Rollbond-Verdampfer-Platte (10, 10') sein kann.

10. Kältemittelkreis nach Anspruch 8 oder 9,
**dadurch gekennzeichnet, dass** die
Temperatur der Entfeuchtungsplatte (40, 40`) unabhängig von der Temperatur der Rollbond-Verdampfer-Platte (10, 10') steuerbar ist oder dass die Temperatur der Entfeuchtungsplatte (40, 40`) mit einer festgelegten Differenz zu der Temperatur der Rollbond-Verdampfer-Platte (10, 10') einstellbar ist.

11. Kältemittelkreis nach einem der Ansprüche 8 bis 10,
**dadurch gekennzeichnet, dass** die
Entfeuchtungsplatte (40, 40`) als weitere Rollbond-Verdampfer-Platte ausgebildet ist.

12. Kältemittelkreis nach einem der Ansprüche 8 bis 11,
**dadurch gekennzeichnet, dass** die
Rollbond-Verdampfer-Platte (10, 10') und die Entfeuchtungsplatte (40, 40`) in dem Kältemittelkreis (30) parallel geschaltet sind.

13. Laborschrank, Klimaschrank, Kälteschrank oder Umweltsimulationsschrank (50) mit einem Probenraum (52) und einer Rollbond-Verdampfer-Platte (10, 10') nach einem der Ansprüche 1 bis 7 oder einem Kältemittelkreis (30) nach einem der Ansprüche 8 bis 12, wobei die Rollbond-Verdampfer-Platte (10, 10') an der Außenseite des Probenraums (52), insbesondere an der Außenseite der Rückseite (54) des Probenraums (52), angeordnet ist.
